# EUROPEAN PATENT APPLICATION

(11) **EP 3 051 595 A1**
(43) Date of publication of application: **03.08.2016**
(21) Application number: 15000270.7
(22) Date of filing: 29.01.2015
(51) Int. Cl.: H01L 31/05, H01L 31/18

(54) **Method and device for making an interconnector for solar cells and such interconnector**

(71) Applicant: Meyer Burger AG, 3645 GWATT (Thun) (CH)
(72) Inventor: Albers, Bas, 8820 Wädenswil (CH)

(57) **Abstract**

The current invention relates to a method for interconnecting photovoltaic devices such as solar cells (2, 3), comprising the steps of:
i. providing at least one electrical wire (7) for electrically connecting at least two photovoltaic devices (2, 3),
ii. providing at least one first photovoltaic device (2) and/or at least one first sheet (4) respectively with at least one surface (5, 29) for receiving at least one first section (6) of the wire (7),
iii. changing the cross-sectional shape of the wire (7) in at least one first and/or one second section (6, 6'), preferably a section for contacting at least one of the surfaces (5, 29), to result in a new non-circular cross-sectional shape, the new cross-sectional shape having a defined spatial orientation to that surface (5, 29) after changing the cross-sectional shape,
iv. maintaining the defined spatial orientation of the section (6, 6') of the wire (7) or changing the spatial orientation of the section of wire (7) in a defined manner prior to and/or while combining and attaching wire (7) to the at least one surface (5, 29).

## Description

### FIELD OF THE INVENTION

The present invention relates to a method and device for making an interconnector for solar cells and such interconnector. The solar cell may be of any technology such as mono- or multi-crystalline, hetero-junction, based on p- or n-type material, bi-facial, thin film and may be used for any suitable module design.

The invention refers to a method for making an interconnector for solar cells according to the preamble of claim 1, the use of the same according to the preamble of claim 11 and a device for carrying out the inventive method according to the preamble of claim 14.

The generation of electrical energy using photovoltaic technology has reached a high standard. However, the production of PV cells and PV modules is still rather complicated and expensive. Also the efficiency of energy generation using PV modules with a maximum efficiency of about 17 per cent is rather low. From an economic point of view the generation of electric power using photovoltaic technology is only acceptable under current conditions if it is supported and/or subsidized by some means, e.g. by the so called 1000 roofs program in Germany or similar programs in California, USA. Thus, in the field of photovoltaic technology there still remains a critical requirement to lower the production costs and enhance the efficiency of the energy generation using PV elements and PV modules.

Commonly used PV cells comprise a semiconductor element with a junction of the type (n⁺n(or p)⁺) on the basis of mono- or multi-crystalline silicon, amorphous silicon and other thin-film semiconductors with an embedded p-n junction. One surface of the element is usually covered with a metal layer, such as aluminium, while the other surface is provided with an anti-reflective coating. Both surfaces are into contact with electrodes, which collect and carry off the generated electrical energy. This structure is embedded between (transparent) protective layers, such as glass and/or a back sheet.

The electrodes interconnecting the cells should make good contact to the surface of the cells (or the metallization thereon), have low resistivity while not shading the front side of the cell too much. At the same time these electrodes should be cost-effective and easy to handle in the production. Such an electrode is e.g. known from WO 2004/021455 A1 (WO'455) "Electrode for photovoltaic cells, photovoltaic cell and photovoltaic module" and US 2011/0197947 A1 (US'947) "Wire network for interconnecting photovoltaic cells". These documents describe the possible use of the inventive electrode and possible implementation of the method for manufacturing them as well as possible devices for carrying out the inventive method.

This electrode described in WO'445 contains wires embedded in an adhesive layer on a transparent foil, the wires being coated with an alloy with a low melting point. In addition, two sets of wires are interconnected by a terminal bar thus forming the electrode for interconnecting solar cells. Also shown are wires having non-circular cross-sections. How these wires are applied to the foil is left open.

The electrode described in US'947 has wires extending over two sheets and is especially suited for being manufactured with the inventive method.

It is the goal of this invention to optimize such electrodes by reducing the need for expensive materials while keeping the manufacturing process simple and robust.

### SUMMARY OF THE INVENTION

These goals are achieved by a method for making an interconnector for solar cells according to the features of CLAIM 1, the use of the same according to the featured of CLAIM 11 and a device for carrying out the inventive method according to the features of CLAIM 14.

According to the invention coatings and/or deformations are only applied where needed, thus saving costs and materials. In addition, the problem of correctly orientating non-circular wires is solved for the first time for industrial applications.

The wire may prior to deformation have any desired cross-section such as (essentially) circular, oval (forming a ribbon), square, rectangular etc. The wire may be part of a grid or mesh. It may be any suitable conductive structure and typically is or contains an elongated conductor portion, even though at small scale it may comprise loops or undulating portions. It may consist of at least one wire, multiple mainly parallel wires, at least one ribbon, multiple mainly parallel ribbons, at least one grid or mesh or any combination thereof.

As was described above, the electrode disclosed in WO'455 is coated with a low-melting alloy or solder, typically melting in the range of 100°C to 150°C. Such alloys contain different metals, like silver or Indium which are relatively costly. It is also possible to use electro-conductive materials composed of or comprising organic adhesives, possibly with metallic or alloy particles. In all cases the reduced usage of these materials will reduce costs. According to the invention this is achieved by only coating the electro conductor means where the coating is needed: where the connection to the photovoltaic device is desired. Moreover, the side of the wire facing away from the sheet and towards the pv-device.

The problem with coating electrical conductor only where needed is that it is hard to make sure that the coating is in the right location (longitudinal location on the pv-device and orientation of the wire relative to the pv-device) when the electrode is used to interconnect the photovoltaic devices.

According to the invention the above problems are solved by changing the cross-sectional shape of the wire only a short time before the wire is brought into contact and attached to the sheet or even when the wire is in contact and possibly already attached to the sheet.

The cross-sectional shape may be changed by deforming the wire. Also applying a coating will change the cross-sectional shape since the coating will form an extrusion on the wire.

The same problems arise when deforming (highly) symmetrical electrical conductor such as wires. When using a round wire, its orientation is not relevant. When the wire is deformed, say to a cross-section forming an equilateral triangle, the wire has to be kept in one of three orientations (agreeing with the 3-fold symmetry). Since the wire may be rather thin, typically the cross-section of the round wire having a diameter of 100-400 µm, this is very impractical in an industrial environment. Again the inventive idea solves this problem by deforming the wire (in this document also called electrical conductor) only a short time before it is brought in contact with the sheet.

More than one coating may be applied, more than one deformation may be carried out and/or any combination of deformation(s) and coating(s) may be combined. Coatings and deformations may be applied to the same sections (also called portions in this document) of the electrical conductor, possibly overlapping, and/or to different portions.

In this document "A and/or B" meaning only A, only B or both A and B simultaneously (A and B being any desirable quantity).

Another advantage of the invention is that the coating(s) and/or deformation(s) are not damaged due to handling, storing (winding up) or shipment. The electrical conductor does not need to be manipulated after being coated and/or deformed and can be integrated in the final product right away.

For example when round wires are used, they may be coated with solder on one side only: the side later facing the photovoltaic device it has to be attached to. If the wires are round it will be very hard to make sure that the right side faces the photovoltaic device when needed. Even if the wires are not round, their small diameters make it difficult to ensure that they are in the correct orientation and lateral position.

According to the invention it is also possible to use a simpler foil for the electrode disclosed in WO 2004/021455 A1. By the inventive method an adhesive may be applied to the electrical conductor (wire) so that no adhesive layer is need on the sheet to hold them. The inventive method ensures that the adhesive is on the right side and in the right location when using the interconnector, not impairing electrical contact to the photovoltaic devices. If in addition to the adhesive a solder is coated to the side of the wire later facing the photovoltaic device, then costs can be reduced even further.

The inventive method further makes it possible to selectively apply a coating to the side of the electrical conductor that later faces the photovoltaic device and/or selectively deform the electrical conductor. Selectively meaning that the electrical conductor is not coated and/or deformed over its complete length, but only in sections (in distinct portions distributed over its length).

According to the invention the spatial orientation of the wire relative to the sheet it has to be applied to is known and since the wire is attached right away, the spatial orientation does not change or can be changed in a controlled manner, always ensuring that the wire is attached to the sheet (also called foil in this document) correctly.

The goal of the invention is to provide optimized electrodes by reducing the need for expensive materials while keeping the manufacturing process simple and robust. Also for the first time a solution is offered to use wires with non-circular cross-sections in an industrial environment.

Preferably the wire is spatially allocated to the sheet is has to be applied to. In that way the wire can be applied to the sheet in exactly the correct orientation and location.

Once the electrical conductor is brought into contact with or even is attached to the sheet (e.g. an insulating or dielectric foil), metals may be coated to the electrical conductor by means that have little spatial resolution such as (electro-) plating, plasma spraying, CVD (chemical vapour dispositioning), PVD (physical vapour dispositioning) or wave soldering. Since the coated material (say solder) will only hold on the metallic surface of the electrical conductor, the coating is only applied where needed. Note that these methods can be used much less efficiently and robustly than when the wire is bare.

In general, any suitable dispositioning means may be used such as electrostatic coating, immersing, wave soldering, ink-jet printing or spraying and any desirably coating may be applied such as a soldering flux, an optical agent to alter reflectivity, an adhesive etc.

The electrical conductor is at least partially coated and/or deformed upstream of the position where the first portion of an electrical conductor is brought into contact with the first surface of that sheet. Upstream meaning that portions of the electrical conductor that are at least partially coated and/or deformed are then moved to a location where the electrical conductor is brought into contact with the surface of that sheet. Normally that portion is then moved further in the same direction, where it e.g. is rolled up or stored to be used later. Note that now the deformation and/coating is protected by the sheet.

Material may also be saved by applying coating to the electrical coating by means that have higher spatial resolution such as inkjet printing, screen printing, laser transfer etc.

The coating may stay on the electrical conductor and be included in the semi-finished or final product or may be removed before, after it has served its purpose. An example of the latter being a solution used for etching or activating (part of) the electrical conductor or a solution for removing a protective layer thereon.

The coating may have any function such as changing optical properties of the electrical conductor (better reflectivity, dark coating for aesthetical reasons, etc.), providing mechanical hold (adhesive for attaching to cell or sheet, etc.), supporting a process carried out later (soldering flux, solvent for attaching electrical conductor to sheet, etc.).

In this document coating means applying a layer of any desired material, e.g. being a porous or compact material and it may have an open or closed cell structure. It may cover complete sections of the wire or only parts thereof.

Deformation of the electrical conductor may be brought about by any mechanical forcing means such as a die, a stamp, a compactor, rolls, a press-form etc. In general the deformation will alter the cross-sectional shape of the electrical conductor in a way that one can clearly distinguish between the electrical conductor before and after the deformation has taken place.

Deformation normally has a noticeable effect on the semi-finished or final product it becomes part of. Markings (for identifying the wire, or end-product) or surface treatment of any kind, however, may also be considered deformations. For this purpose e.g. a laser may be used.

Even if the electrical conductor comprises a mesh or a grid the invention can be beneficial. Since coating and deformation is only done shortly before the mesh or grid is applied to the sheet, the following advantages occur:
- No grid or mesh with expensive coating needs to be kept in stock (binding resources)
- It can be decided in a late phase what kind of coating and/or deformation is used (not generating waste when switching to a different designs)
- Since the coating is applied at a late stage it does not degenerate (oxidation etc.)
- The grid or mesh cannot be applied facing the wrong direction.
- If the structure of the photovoltaic devices changes, the coating and/or deformation can be applied to the changed locations easily
- No damage due to handling, shipment or storage will occur
- The exact location of the deformations and/or coatings may be determined "on-line", so that tolerances in length of the mesh or grid may be compensated.

A mesh may for example be made by intertwining wires or by other technologies for example such as disclosed in US 8,569,096 B1.

A further advantage of the invention is that it is a solution that is independent of the photovoltaic devices that are connected and thus is very useful for module manufacturers that do not have their own cell production.

The sheets may be or contain any of a foil, web, spunbond, nonwoven fabric or any combination thereof. The material forming the sheet may be sprayed onto the electrical conductor, thus e.g. forming a nonwoven fabric as it solidifies. For the application as described in WO'455, it should prevent encapsulant material from penetrating between the electrical conductors and the photovoltaic devices during lamination, while itself adhering to the cells after lamination. Moreover, normally an encapsulant is placed between the solar cell matrix and the outer layer of the module. This encapsulant is softened during lamination to adhere to the outer layer (glass or back sheet) and to the matrix. As the encapsulant is soft it may penetrate between the electrical conductor and the photovoltaic device, thus preventing good electrical contact between the both. Note that this is possible since at the start of the lamination, the wires are not yet attached to the solar cells. If the sheet is a web or has holes or punctures in it, it must still ensure, at least locally, that no encapsulant can penetrate beneath the electrical conductor, for example by slowing down the flow of encapsulant (small openings) or by only providing holes at a distance of the wires so that the wires can bond to the cells first.

The sheet of material that later covers the "sunny side" (side facing the sun in usage) of the photovoltaic device should be transparent for the appropriate wavelengths, so that light can reach the cell easily. It can for example be made of Low-density polyethylene, possibly with EVA content, Polyolefin, elastomers, lonomer, Polyethylene terephthalate, silicones, PMMA (Poly(methyl methacrylate)) or ETFE (Ethylene tetrafluoroethylene). Normally such transparent materials are non-conductive, but any amount of conductivity (for example a conductive transparent layer) could contribute to a lower series resistance between the cells and therefore would be beneficial as long as it is transparent enough or only extends on the back side. The sheet may be made of or comprise the same or different materials (e.g. having an adhesive layer), preferably selected from materials mentioned above. A sheet that in the module does not cover the sunny side of a solar cell, it may for example extend between adjacent solar cells, may be of an opaque (conductive) material or of a white or reflective material. It may even comprise a metal sheet such as an aluminium foil or metallic particles. For bi-facial cells it is more likely to use transparent sheets on the side normally not facing towards the suns. Since demands are different (e.g. less UV hits this side), the foil may be adapted to that.

Preferably the wire and/or sheet are part of an endless (meaning much longer than what is needed for forming an inventive interconnector) supplies and are cut to the right length when forming the interconnector. Multiple wires preferably being supplied on one or multiple spools or rolls.

The sheet may comprise a foil or a sandwich of foils. It may be transparent foil (especially when applied to the sunny sides of a photovoltaic device) or as non-transparent foils (especially when applied to the non-sunny-side of a photovoltaic device). In both cases the foil may be conductive. In the latter case the foil may be or comprise a metal sheet.

Multiple sheets may be brought into contact with the electrical conductor, the sheets preferably each being attached thereto. The sheets may be used to extend next to one or multiple photovoltaic devices. They may all be brought into contact with one side of the electrical conductor or be distributed over two, opposite sides. The may or may not (partially) overlap.

In this document coating and deforming (and any form thereof) always means completely and partially coating and deforming respectively.

The steps of the methods for forming an interconnector according to the invention are preferably carried out in the order given, but if beneficial the order of the steps may be altered.

Photovoltaic devices may e.g. be solar cells, strings of solar cells, sub-panels, matrices of solar cells, parts of or on thin film solar panels that need to be connected, etc. Any type of solar cell may be used such as MWT, Back contact cells, hetero-junction cells, bus-bas-less cells, etc.

With changing the cross-sectional shape of the wire, an alteration of the cross-section over a certain length of the wire is meant. Preferably the cross-section is thus changed over that length, resulting in a more or less constant cross-section over that length. Preferably the cross-section is changed over more than 1 mm, even more preferably over more than 5mm such as over more than 10mm. Preferably the cross-sectional shape is changed in a defined manner. Preferably the portion of the wire who's cross-sectional shape is changed is received near by the surface of the at least one photovoltaic device and/or at least one first sheet near the centre of that surface. Preferably the section with changed cross-sectional shape is longer than 10% of the length of the surface of the at least one photovoltaic device and/or at least one first sheet, that length being measured in the direction the wire extends in.

Preferably the first section of the wire being allocated to the first photovoltaic device and/or to the first sheet, preferably prior to changing its cross-sectional shape. Once this allocation has been done, the wire can be prepared exactly in the correct location and be placed in the correct positon on the first photovoltaic device or on the first sheet respectively. Moreover, the orientation of the wire can be controlled so that also its correct orientation also can be ensured.

Preferably the cross-sectional shape of the wire is changed by at least partially deforming and/or at least partially coating of that wire. As indicated above, changing the cross-sectional shape of the wire by coating and/or deforming leads to numerous benefits, most importantly to cost reduction.

Since the allocation of the wire relative to the sheet or photovoltaic device it has to be attached to is done after unwinding the wire from its spool, the spatial orientation of the electrical wire prior to changing its cross-sectional shape is not defined, but this is not a problem to the current invention since this orientation does not have to be known. Also the orientation of the wire does not have to be fixed at this point. This makes the handling of the wire much easier.

Preferably the wire prior to changing its cross-sectional shape has at least a 4-fold rotational symmetry around its longitudinal axis, preferably having an at least 5-fold rotational symmetry around its longitudinal axis, the wire preferably having a mainly circular cross-section. By using round or roundish wire, standard products can be used that are more cost effective. Also the wire is free to twist without deformation of its cross-section. In addition round and roundish wires are easy to store since their shape is not particularly prone to deformations.

Normally only the wires contained in a plurality of parallel wires or grid have rotational symmetry (not the plurality or grid itself) about its central, longitudinal axis. By coating and/or deforming such wires, it becomes important how the electrical conductor is attached to the sheet. By changing the cross-sectional shape (e.g. by coating and/or deforming) the electrical conductor, its (now possibly including the coating material) rotational symmetry may be reduced, meaning that an m-fold rotational symmetry is reduced to an n-fold rotational symmetry, with m and n being natural numbers and m>n.

Preferably the cross-sectional shape of the wire being changed while combining and attaching wire to the surface and/or after the wire has been combined and attached to the surface ensuring that the wire will not twist because its free length can be kept small and even be reduced to zero in the latter case.

In this document the terms "being combined" and "being brought into contact" are used interchangeably.

Preferably at least one second photovoltaic device and/or at least one second sheet is provided with respectively at least one surface for receiving at least one second section of wire. By attaching a second sheet, an electrode can be made as proposed in WO'455 and US'947: one sheet being placed adjacent a first solar cell and a second sheet being placed adjacent a second solar cell. The first and second sheet may overlap or may not overlap. If photovoltaic devices are interconnected directly by the wires, attaching a second photovoltaic device will result in a small string. In a hybrid mode, a sheet and a photovoltaic device may be attached to the at least one wire.

Clearly strings of inventive interconnectors can be made by repeating the inventive method, applying numerous first and second sheets and/or photovoltaic devices to the at least one wire such as a multitude of parallel wires. Cutting the electrical conductor will e.g. result in interconnectors for interconnecting two photovoltaic devices or assemblies of photovoltaic devices.

If two directly interconnected photovoltaic devices in a solar module have opposite polarities facing in one direction (say the first solar cell has the plus pole on the sunny side and the second one has the negative pole on the sunny side), the first and second sheet are preferably applied to same side of the at least one wire. If two directly interconnected solar cells in a solar module have equal polarities facing in one direction (say both the first and second solar cell have the plus pole on the sunny side), the first and second sheet are preferably applied to opposite sides of the electrical. In that case, the first surface of the first sheet and the first surface of the second sheet face toward each other when applied to the sheet.

The first and second sheet may overlap, preferably when extending on opposite sides of the electrical conductor.

When being brought into contact or when in contact with a first and/or a second sheet, the electrical conductor may be coated and/or deformed in any section thereof such as in a section partially or completely overlapping the first and/or second sheet or outside of these portions.

When interconnecting solar cells, the wire may e.g. be coated only where the wires are soldered to the photovoltaic devices. A deformation may be brought about over the complete range of the photovoltaic device, e.g. to gain better scattering of light of the wires.

The at least one first section and the at least one second section of the at least one first photovoltaic device/sheet and the at least one second photovoltaic device/sheet may (partially) overlap or not overlap. In the former case, sheets/photovoltaic devices are normally applied to opposite sides of the electrical conductor.

In this document "is brought into contact" means during the act of being brought into contact. Moreover, shortly before contact is established. A portion of an electrical conductor is in contact with the sheet/photovoltaic device when at least a range of the electrical conductor touches the sheet/photovoltaic device it is/will be attached to with at least part of its surface.

Preferably the wire is already attached to a preceding sheet or photovoltaic device when its cross-sectional shape al changed. The wire may be cut from the preceding sheet or photovoltaic device when no connection is required, the preceding sheet or photovoltaic device thus (temporarily) serving to secure the orientation of the wire.

Sheets may extend over the complete length of the solar cell or over a significantly smaller portion thereof, the latter saving material and blocking less light with the sheet, the length being measured in the longitudinal direction of the electrical conductor. It is beneficial to let the sheet extend in the gaps between the solar cells. Multiple sheets may extend adjacent the surface of the solar cell leaving gaps between them, so that again less light is blocked.

If multiple sheets or photovoltaic devices are used, according to the invention the number is not limited to one or two and can be any suitable number, the positions or sections brought into contact with these respective sheets and photovoltaic devices, preferably being attached thereto, may each be coated, not be coated, be deformed, not be deformed or any combination thereof, possibly distributed over its length.

All described in this document related to sheets and electrical conductors or wires and the methods for making them holds for all sheets and all electrical conductors or respective portions thereof in the interconnector.

Since the first and or second section(s) is/are combined and attached to the surface of the sheet or photovoltaic device, it is ensured that the coated and/or deformed portion(s) is/are kept exactly in the right position(s) and orientation(s), also during later processing steps, such as during lamination where pressure is applied to the now normally asymmetrical electrical conductor, thus biasing it to change its position or orientation.

Preferably the coated and/or deformed first and/or second sections are completely brought into contact with and/or are attached to the sheets or photovoltaic devices for maximal stability.

Preferably the wire protrudes from the at least one first sheet and/or at least one first photovoltaic device and/or from at least one second sheet and/or at least one second photovoltaic device after combining and attaching wire thereto. Moreover, the electrical conductor or wire extending past the edges of the sheet or photovoltaic device, parallel to its main surface. In that way at least two opposite portions of the electrical conductor are not covered and can respectively be attached to a bottom and a top side of two solar cells to be interconnected. Preferably the wire has a (straight) length larger than 50% of the length of an edge of the at least one first sheet and/or at least one first photovoltaic device it is attached to, the edge extending in the same direction as the electrical interconnector, preferably larger than 80%, the edge being one of its main edges. In this way the electrical conductor can at least partially support the current collected from one photovoltaic device and transport it to a next photovoltaic device.

Preferably the wire is cut to form an interconnector containing two sheets or to interconnect two photovoltaic devices. In this way an interconnector is obtained for connecting two photovoltaic devices or two interconnected solar cells. Multiple such interconnectors can be used to form a string of photovoltaic devices and even a matrix of photovoltaic devices. Two thus interconnected photovoltaic devices can be extended to a string of more (serially) interconnected photovoltaic devices.

The electrical conductor preferably extends parallel to the first surface of the first and/or second sheet or photovoltaic device, preferably parallel to an edge of that the first and/or second sheet or photovoltaic device. The first surface may be placed flat on solar cells to be connected.

Preferably the electrical conductor is formed by a plurality of essentially parallel wires or structured wires that extend parallel to each other. These wires may also intertwine as to form a grid or mesh.

The electrical conductor may be attached to a sheet or photovoltaic device shortly after or even before it is coated and/or deformed, ensuring the spatial orientation of the electrical conductor to the sheet. Thus the spatial orientation and position relative to the photovoltaic device an interconnector is applied to in the solar module is fixated. If the electrical conductor is heated and thus attached to the sheet (by partially melting the latter), it is beneficial to attach the electrical conductor to the sheet essentially over the complete length of the electrical conductor or sheet, whichever is shorter.

When used as described in WO'455 or US'947, the sheet is placed flat on the solar cell (with the electrical conductor facing the cell), the solar cell extends essentially parallel to the sheet. Portions of the electrical conductor facing away from the sheet therefore automatically face the solar cell and consequently the coating in these portions will touch or at least face the cell.

Preferably the at least one wire is at least partially coated and/or deformed when the first and/or second section thereof has been attached to the sheet or photovoltaic device, meaning that the first and/or second section is still attached to the sheet or photovoltaic device as this happens. If a portion already has been brought into contact and preferably has been attached to the sheet or photovoltaic device before the electrical conductor is coated and/or deformed, the orientation of the electrical conductor is even better ensured. The term "attaching" (and other forms thereof) in this document meaning that the electrical conductor is, at least temporarily, held in the correct orientation by the surface. An after-treatment such as cooling or hardening may cause the electrical conductor to be held more firmly or more permanently so that the interconnector or the interconnected photovoltaic devices can be processed more easily without taking damage. The electrical conductor may e.g. be temporarily held by electrostatic charging.

Preferably the first and and/or second sheet(s) are electrically insulating, preferably being an electrically insulating foil, web, spunbond or nonwoven fabric. The sheet may also be dielectric. As described in WO 2004/021455A1 an insulating sheet, preferably made of a polymer is used beneficially. Alternatively, the sheet could form a layer with the area of mainly the complete solar module and/or a layer forming at least part of the encapsulant and/or a layer forming the outer layer of the solar module such as a glass plate or back-sheet. If the sheet does not extend on the sunny side in the module, it may be conductive, and usually not-transparent, to support the current in the module.

The current invention may be used for interconnecting all sorts of photovoltaic devices such as solar cells, strings of solar cells, sub-panels, matrices of solar cells, parts of or on thin film solar panels that need to be connected, etc. Any type of solar cell may be used such as MWT, Back contact cells, hetero-junction cells, bus-bas-less cells, etc.

If the sheet does not have adhesive properties itself, preferably the wire(s) is/are attached to the first and/or second sheet or first and/or second photovoltaic device by means of a (conductive) adhesive. The adhesive preferably being applied using the inventive method. The wire may be attached to a sheet by heating any of the wire(s), the sheet(s) or both. Alternatively (elongated) beads of a polymer material may be applied to the electrical conductor.

Preferably the cross-sectional shape in a first range of the first and/or second section of the wire facing toward the surface it is received by is not changed, especially not coated,
preferably the cross-sectional shape of essentially the complete first range of the first and/or second section in contact with the surface not being changed, especially not being coated. For example these ranges in the methods described in WO'455 or US'947 do not touch the solar cell it is connected to. Therefore there is no need to coat them with solder and/or flux, thus saving material and reducing the amount of flux in the solar module, which may over time effect the materials in the module.

In this document "not being coated", "not coated" or the like meaning that in the inventive method no coating is applied. The electrical conductor may, however, already have a coating.

Preferably the cross-sectional shape in a first range of the first and/or second section of the wire facing toward the surface it is received by is changed, especially deformed, preferably the cross-sectional shape of essentially the complete first range of the first and/or second section in contact with the surface being changed, especially being deformed. In the methods described in WO'455 or US'947, it is beneficial to use multiple parallel wires with triangular cross-sections as electrical interconnector means, the point of the triangle facing toward the sheet. This reduces the effective shading of the solar cell, since sun light is more likely to reflect of the wires onto the cell. For bifacial cells both sides of the solar cells are the sunny side and therefore deformations are beneficially applied to opposite side of the electrical conductor.

Preferably the cross-sectional shape is changed e.g. coated and/or deformed in a structured manner, meaning that portions or ranges of the electrical conductor are coated and/or deformed that do not touch. Moreover, not the complete length of the electrical conductor is coated and/or deformed, but only patches thereof. In this way only portions of the electrical conductor may e.g. be coated that later are actually soldered to a solar cell, thus e.g. not coating between two cells. Structure may be provided in axial direction of the electrical conductor (varying in direction the current is transported) and/or in tangential direction (varying around the circumference of a wire contained in the electrical conductor, perpendicular to the axial direction), or any combination thereof.

Preferably the electrical conductor and the sheet or photovoltaic device are moved at the same time. Moreover, they are moved in such a way that they can be brought in contact with each other without relative movement (in their transportation direction) without standing still, leading to higher throughputs. Also the first and/or second sheet and the electrical conductor do not have to be accelerated what would lead to less throughput, tension peaks in the materials and would require additional controls.

Preferably the first and/or second sheet and/or first and/or second photovoltaic device and respectively the first and/or section of the wire are moved essentially with the same speed (v) at the moment the cross-sectional shape of wire is changed, preferably by coating and/or deforming and/or when the wire is attached to the first and/or second sheet and/or the first and/or second photovoltaic device, the speed preferably being larger than 0.01 m/s, even more preferably larger than 0.05m/s, most preferably larger than 0.1 m/s so that interconnectors can be manufactured in industrial quantities and the tension in the electrical conductor can be kept constant. With a wire speed of 0.156m/s and cells of 156mm x 156mm, it takes 2 x 156 mm / 0.156m/s = 2s to make an interconnector with the length of two cells and thus 1800 such interconnectors can be made per hour. Clearly increasing this speed further would be beneficial. Here "same velocity" meaning having a speed with essentially the same amplitude and direction.

Preferably the cross-sectional shape of the first and/or second section of wire is changed, preferably being coated and/or deformed, when that first and/or second section of wire is not further away from respectively the first and/or second sheet and/or first and/or second photovoltaic device than 4 meters, preferably not further away than 2 meter, even more preferably not further away than 1 meter, this distance preferably being measured in upstream direction in a straight line only.

By changing the cross-sectional shape of the electrical conductor right before or even after the electrical conductor has been brought (and still is) in contact with the sheet or photovoltaic device, its orientation and position relative to the sheet can be ensured. The term "not further away" in this document means that the distance from the portion to the location where the electrical conductor is coated and/or deformed is not bigger than the given quantity. This distance is measured in a straight from the portion to the location where the electrical conductor is coated and/or deformed while the electrical conductor is being coated and/or deformed. Preferably this distance is only determined in upstream direction since the coating and/or deforming of the wire prior to (upstream of) the sheet or photovoltaic device being brought into contact with the electrical conductor ensures that the electrical conductor can treated readily while ensuring the orientation of the electrical conductor relative to the sheet or photovoltaic device.

For the same reasons, alternatively the cross-sectional shape of the wire may be changed, preferably coated and/or deformed, later than 400 seconds before the first and/or second section of the wire is in contact with respectively the first and/or second sheet and or first or second photovoltaic device, preferably later than 100 seconds before that even more preferably later than 20 seconds before that.

Normally, once the electrical conductor has been brought into contact with a sheet or photovoltaic device, it stays in contact therewith. Moreover, there is a last time that the electrical conductor is brought into contact with a sheet and from there on is not disengaged therefrom. The term "has been brought into contact with" and "combining and attaching" means "has been bought into and still is in contact with/attached to". Normally the wire is thus attached to and stays attached to the sheet or photovoltaic device for economic life-time of the photovoltaic device.

Preferably the first and/or second section of wire as its cross-sectional shape is changed e.g. by means of coating and/or deforming is located in a plane perpendicular to the surface of respectively the first and/or second sheet and/or first and/or second photovoltaic device and parallel to an edge thereof extending in the direction the wire(s) extends in, preferably wire extending to tangentially touch surface. In that way no twist (rotation around axial axis of the electrical conductor) occurs. To "tangentially touch" here meaning that where the electrical conductor first touches the sheet, both extend in the same direction. The electrical conductor may follow any trajectory in this plane.

In one option the cross-sectional shape of wire is changed, preferably coated and/or deformed in a range inside first and/or second section of the wire so that the coated and/or deformed portion is coated and/or deformed and directly brought into contact and normally attached to the sheet or photovoltaic device.

Alternatively the cross-sectional shape of wire is changed, preferably coated and/or deformed in a range outside first and/or second section of the wire. In that way, the coated and/or deformed portion is coated and/or deformed and not directly brought into contact and normally attached to the sheet or photovoltaic device, thus not disturbing process of deforming and/or coating. The deformed and or coated upstream portion, however, is brought into contact with and normally attached to a sheet or photovoltaic device in a later stage. Everything described in this document in relation to the first and second portions is also applicable to the first and second upstream portions.

Preferably the wire is coated with a solder, preferably a low-melting solder, an adhesive, a conductive adhesive, a soldering flux or any combination thereof, multiple coatings preferably being applied at different times, preferably in different stations, e.g. for the usage as described in WO'455 or US'947, these options being e.g. applicable in the following situation:

A solder may be applied if the electrical conductor is attached to a solar cell using conventional means such as inductive soldering or laser soldering.

A low-melting solder may be applied if the conductor is attached to the solar cell during the lamination process where the temperatures are too low to use normal solder. A low-melting solder typically having a melting point lower than 180°C, preferably lower than 150°C.

An adhesive may be applied on the electrical conductor for attaching the latter to a sheet of photovoltaic device. In this case the adhesive may be applied to the side of the electrical conductor touching the sheet.

A conductive adhesive may be used for attaching the electrical conductor to the solar cell. In this case, the adhesive is applied to the side of the electrical conductor facing toward the solar cell.

A soldering flux may be applied to the side of the electrical conductor that comes in contact with the photovoltaic device. In this case, first a solder may be applied with the inventive method, thus applying two coatings with the inventive method, possibly the coating being applied in different stations. Stations in this document meaning distinct locations. These locations may be enclosed by one housing or may each be enclosed by a housing of its own.

Preferably at least two wires being provided, the wires preferably extending mainly parallel at least when attached to the surface and/or the wires forming a mesh or grid depending on the design of the photovoltaic devices to be connected and especially on the fact if the current is mainly supported by the (metallization on the) photovoltaic device or by the inventive interconnector. When using multiple parallel wires, the advantages of the technology described in WO'455 or US'947 may be obtained.

In a further aspect of the invention an interconnector is provided for interconnecting photovoltaic devices and/or interconnected photovoltaic devices as such comprising:
- at least a first sheet and/or a first photovoltaic device respectively with at least one surface;
- at least one electrical wire attached to that surface;
- the wire having at least one first portion with a non-circular cross-sectional shape and a second portion with a different cross-section, preferably having at least a 4-fold rotational symmetry around it longitudinal axis , preferably having an at least 5-fold rotational symmetry around it longitudinal axis, even more preferably that portion having a mainly circular cross-section.

The sheet and/or photovoltaic device ensuring the position and orientation of the wire, especially the coating and/or deformation of the wire relative to the sheet and/or photovoltaic device. Due to the reduced symmetry the orientation and position must be controlled accurately.

For attaching a second solar cell, preferably one second photovoltaic device and/or at least one second sheet is provided that the at least one wire is/are also attached to. The first and second sheets or photovoltaic devices may be applied on the same side of the wire or on opposite sides. Sheets may or may not overlap.

In a further aspect of the invention a system for manufacturing an interconnector or interconnecting photovoltaic devices such as solar cells is provided that comprises:
- means for providing at least one electrical wire to a joining region;
- means for providing a first sheet or a first photovoltaic device to that joining region; and
- means for changing the cross-sectional shape of the wire, resulting in a new non-circular cross-sectional shape before it is provided to that joining region or while it is in that joining region. A system may be seen as being one or multiple devices or machines interacting with each other or treating one product. The system preferably comprises means for changing the cross-sectional shape, preferably containing means for at least partially coating and/or deforming wire. Preferably means are provided for providing at least a second sheet and/or at least a second photovoltaic device to the joining region so that multiple photovoltaic devices can be interconnected.

In order to attach the electrical conductor to the sheet or the photovoltaic device, preferably means for bringing a first and/or second section of the wire into contact with the surface of respectively the first and/or second sheet and/or first and/or second photovoltaic device are provided, the contact being established in the joining region. Preferably the system further comprising means for attaching the first and/or second section of the wire to the surface thereof.

In order to achieve a high throughput and proper orienting and location of the wire on the sheets or photovoltaic devices, the means for at least partially changing the cross-section shape of wire, preferably for coating and/or deforming wire, are located at a distance closer than 4 meters from the joining region, preferably closer than 2 meters, even more preferably closer than 1 meter, the distance preferably measured in upstream direction of the electrical conductor in a straight line.

Preferably means are provided for transporting the electrical conductor with a speed larger than 0.01 m/s, even more preferably larger than 0.05m/s, most preferably larger than 0.1 m/s.

If multiple coatings and/or deformations are applied, the first and second means for changing the cross-sectional shape of the wire, preferably means for coating and/or deforming the wire, are preferably arranged in different stations.

Changes to the cross-sectional shape are beneficially applied upstream of the joining region and thus prior to bringing the electrical conductor and the sheet into contact since at that point the electrical conductor is better accessible and the sheet or photovoltaic device will not be impaired due to changing of the cross-sectional shape of the electrical conductor.

Especially coatings may be beneficially applied when the electrical conductor has been brought into contact or even been attached to the sheet or photovoltaic device since now part of the electrical conductor is shielded and can no longer be coated, as was described above.

### BRIEF DESCRIPTION OF THE DRAWINGS

For a better understanding of the nature of the present invention, reference should be made in the detailed description taken in conjunction with the accompanying drawings in which:
FIG. 1 shows an embodiment of the interconnector according to the inventive method from the side.
FIG. 2 shows two photovoltaic devices interconnected by wires.
FIG. 3 shows a conductive electrode forming a mesh or grids that can be used in the inventive method.
FIG. 4 shows an electrical conductor extending adjacent a sheet.
FIG. 5 shows a cross-section of wires with a coating on a sheet.
FIG. 6 shows a cross-section of a grid with a coating on a sheet.
FIG. 7 shows a cross-section of deformed wires with a coating on a sheet.
FIG. 8 shows a wire with two coatings applied thereto.
FIG. 9 shows a device for carrying out the inventive method for forming an interconnector.
FIG. 10a shows a solar cell with point contacts or point-like contact regions.
FIG. 10b shows the solar cell from figure 10a with wires attached thereto.
FIG. 11 shows how two solar cells may be interconnected using an inventive interconnector.
FIG. 12 shows how two solar cells may be interconnected according to the invention.

### DETAILED DESCRIPTION OF THE INVENTION

The present invention will be described with reference to exemplary embodiments and the present invention is not limited to particular interconnectors, devices, use or methods, except as defined in the appended claims. Embodiments of the present invention may be used with a variety of methods and systems. It will be apparent to one skilled in the art that the present invention may be practiced in a variety of ways within the scope of the claims. All features shown in relation to the figures may be applied mutatis mutandis to the invention as described in the claims and in the claim description.

As used herein, the indefinite article ("a", "an") denotes the presence of at least one of the referenced item, and the term 'a plurality' or 'multiple' denotes the presence of more than one.

In the figures only parts essential for the current invention are shown schematically, for better understanding the invention.

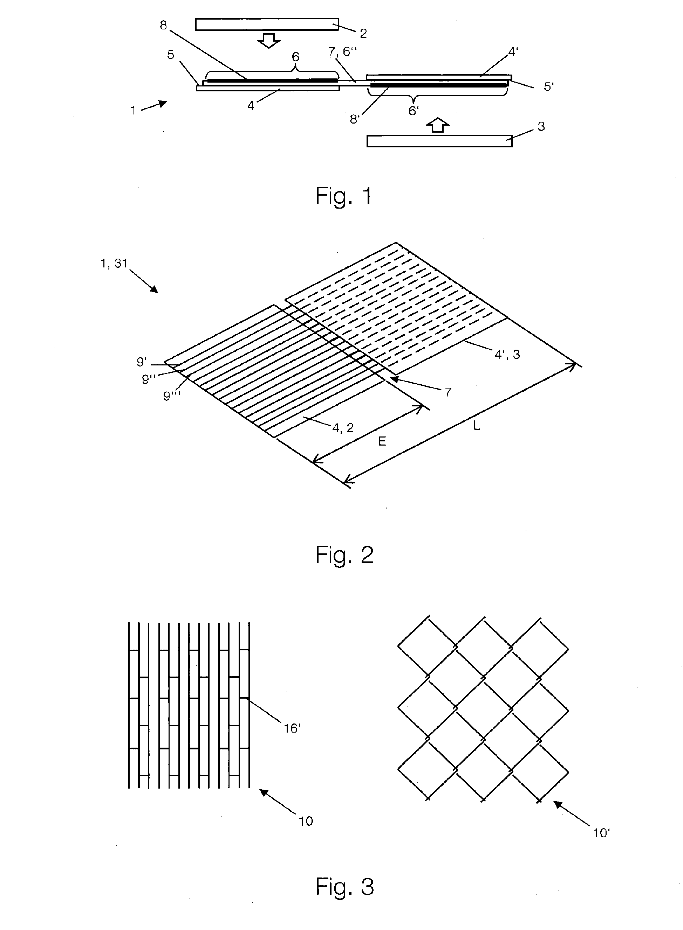

Figure 1 shows an embodiment of an interconnector 1 for solar cells 2, 3 according to the present invention. An electrical conductor or wire 7 extends parallel to a first 4 and a second 4' sheet. A first portion 6 and a second portion 6' of the electrical conductor 7 have respectively been brought into contact with the respective surfaces 5, 5' of the first 4 and the second 4' sheet and are attached thereto. A first coating and/or deformation 8 and a second coating and/or deformation 8' have been applied to the electrical conductor 7 while the electrical conductor 7 was brought into contact with the sheets.

A first photovoltaic device 2 and a second photovoltaic device 3, here both solar cells are shown. The respective arrows indicate how they are brought into contact with the interconnector 1 when interconnecting the cells 2, 3. In the shown embodiment, the cells 2, 3 are placed against coatings 8, 8' respectively. The coating may e.g. be a (low-melting) solder or a conductive adhesive and thus be used for contacting the solar cells 2, 3.

In the embodiment shown in figure 2, the electrical conductor 7 comprises multiple wires 9'-9"' (only three wires having a numeral for clarity). The wires 9'-9"' have been brought into contact with a first photovoltaic device 2 and a second photovoltaic device 3 and are attached thereto. The cross-sectional shape of portions 6, 6' (figure 1) has been changed. In an intermediate portion 6" of wire 7, the cross-sectional shape has not been altered.

The wires extend parallel to a main edge E (parallel to the direction the wire(s) extend in) and the main surface of the photovoltaic devices 2, 3. The length L of the wires is about 100% larger than the length of main edge E.

According to the invention the electrical conductor 7 may comprise wires, a mesh or grid 10, 10' as shown in figure 3 or any other elements. The mesh or grid 10 may be interpreted as essentially parallel wires interconnected by cross-connectors 16'.

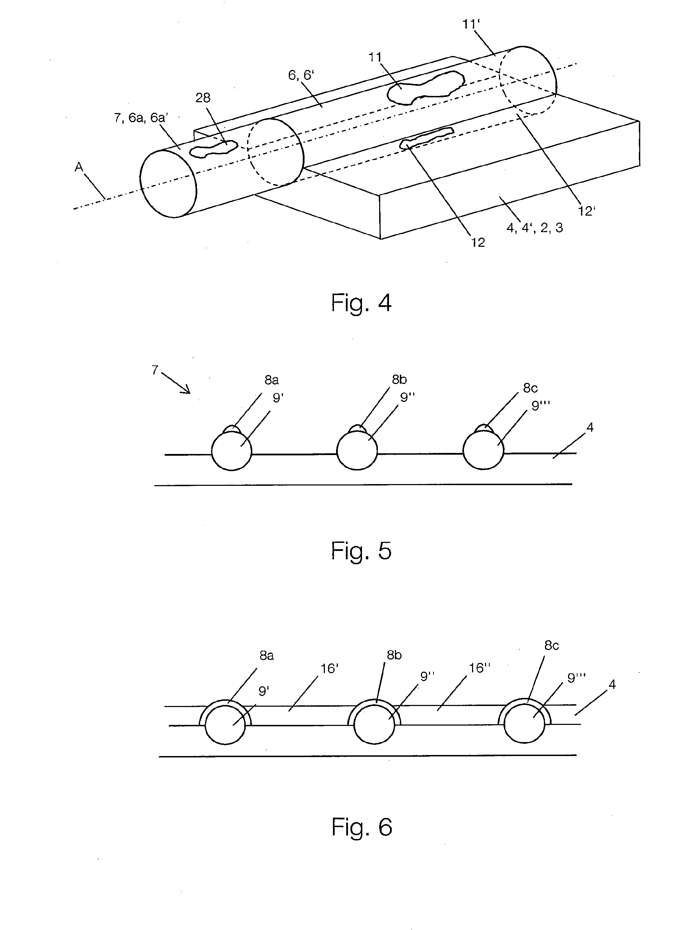

According to the invention the cross-sectional shape of the electrical conductor 7 (having longitudinal axis A) is changed, e.g. coated, while being brought into contact with sheet 4 or photovoltaic device 2. As shown in figure 4 (showing the cases for the first and second portion of the electrical conductor 6, 6' and for sheets and photovoltaic devices), the electrical conductor 7 (here only one of e.g. a plurality wires being shown) is attached to the sheet 4, 4'/photovoltaic devices 2, 3. The coating may be applied to a first range 11 that later will face the cell (when wire is attached to sheet) and not in a second range 12 facing the sheet 4, thus leading to the advantages as previously described. In this case the coating may be a conductive adhesive or a solder. Alternatively the coating may be applied to a second range 12 that faces the photovoltaic device 2 and not to a first range 11. In this case he coating is e.g. used for attaching wires to the photovoltaic device and may e.g. be an adhesive or solder. Alternatively the coating may have desirable optical properties such as reflective properties.

Also shown in figure 4 is that the coatings or deformations may only extend in ranges 11, 12 of the portion 6, 6' of the electrical conductor 7. Alternatively the coatings may extend over the complete length of portion 6, 6' indicated by 11' and 12'.

Coatings may be applied to a range 28 outside portions 6, 6' such as in upstream portions 6a and 6a'.

Even though described here in relation to coatings, the same holds for deformations.

Figure 5 shows an embodiment were the interconnector 1 contains wires 9', 9", 9"'attached to a sheet 4. Only three wires are shown, whereas normally an interconnector will contain much more wires, such as between 20 and 40 wires. A coating 8a-8c has been applied to respectively the top of the wires 9'-9"'. The coating does not cover the complete free surface of the wires thus saving material used for the coating. The coating may e.g. be applied by means of inkjet printing, (plasma) spraying or any other means with enough spatial resolution.

Figure 6 shows an interconnector 1 having wires 9'-9"' on a sheet 4 that have a coating 8a-8c over their complete free surface. Such a coating may e.g. be applied by means of (electro-) plating, wave soldering or e.g. any method that can apply a coating to a metal only. The wires 9'-9"' are interconnected to form a grid by cross-connectors 16' and 16" thus forming the wires into a grid or mesh.

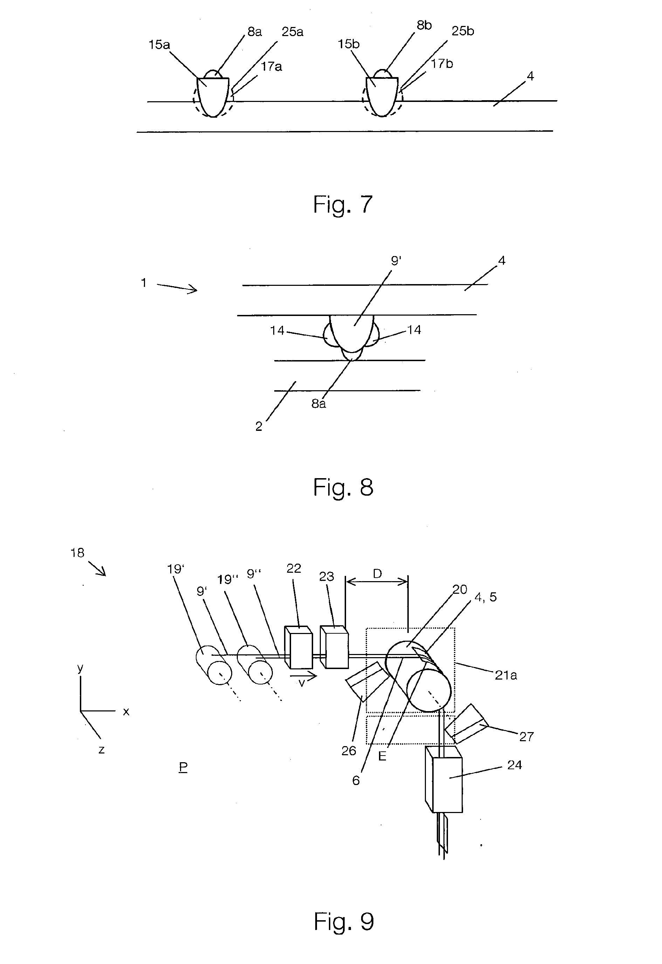

Figure 7 shows two deformed wires 15a, 15b attached to a sheet 4. The wires used to be round as indicated by the contours 17a and 17b. The wires initially had symmetrical portions 25a and 25b. A coating 8a, 8b has been applied to respectively deformed wires 15a and 15b. Moreover, the coating is applied to the side of the wires that later faces the solar cell. The coating 8a, 8b may e.g. be a conductive adhesive, a solder or a flux. The shape of the wires 15a, 15b is such that light reaches the surface of the solar cell more easily. The deformation and the coating are normally applied in different stations.

Figure 8 shows part of an interconnector 1 according to the invention. Shown is a wire 9' brought into contact and attached to a sheet 4. The interconnector is placed adjacent a solar cell 2. The wire 9' is deformed and has a first 8a and a second coating 14, respectively begin solder for attaching the wire 9' to the solar cell 2 and a barrier for hindering material from sheet 4 from penetrating between the solar cells 2 and the solder 8a during lamination when the solder has not yet bonded to the cell 2.

Figure 9 shows an embodiment of a device 18 for manufacturing the interconnector 1 shown in figure 8 according to the inventive method. Wires 9', 9" (here only two wire are shown for clarity) on rolls 19', 19" are brought into contact with a sheet, here a dielectric foil 4. The foil 4 is supplied to a heating drum 20 by sheet supplying means 26 in a first joining region 21 a, where the wires 9', 9"melt into the foil 4 and thus are attached thereto while being brought in contact therewith. Second means 27 for providing a sheet are provided downstream of heating drum 20 to a second joining region 21 b. This may e.g. be a nozzle for applying a polymer bead on the wires.

The wires 9', 9" and the foil 4 are moved synchronously by the wire coils 19', 19" and heating drum 20 respectively. Here they are moved with the same velocity v (same absolute value or speed and direction).

While a portion 6 of wire 9' is brought into contact with foil 4, the wires are coated and/or deformed in stations 22, 23. In a first station 22 the wires 9', 9" are deformed. In station 23 coating 8a is applied (see figure 7). In station 24, when the wires are in contact with and attached to the sheet, here a dielectric foil 19, soldering flux is applied, e.g. by electro-static coating.

The minimal distance in upstream direction between the locations where the wires 9', 9" are brought in contact with and here also attached to the sheet 4 and the stations 22, 23 where the wires are coated and/or deformed is indicated by D.

A plane P parallel to the xy-plane extends perpendicular to first surface 5 of the first sheet 4 and parallel to an edge E thereof that extends in the direction the wires extend in.

Normally foils 4 will be applied one next to the other leaving no or a small gap between then. The foils may be applied to the same or opposite sides of the wires. Possible relative positions of the foils can be found in e.g. US'947.

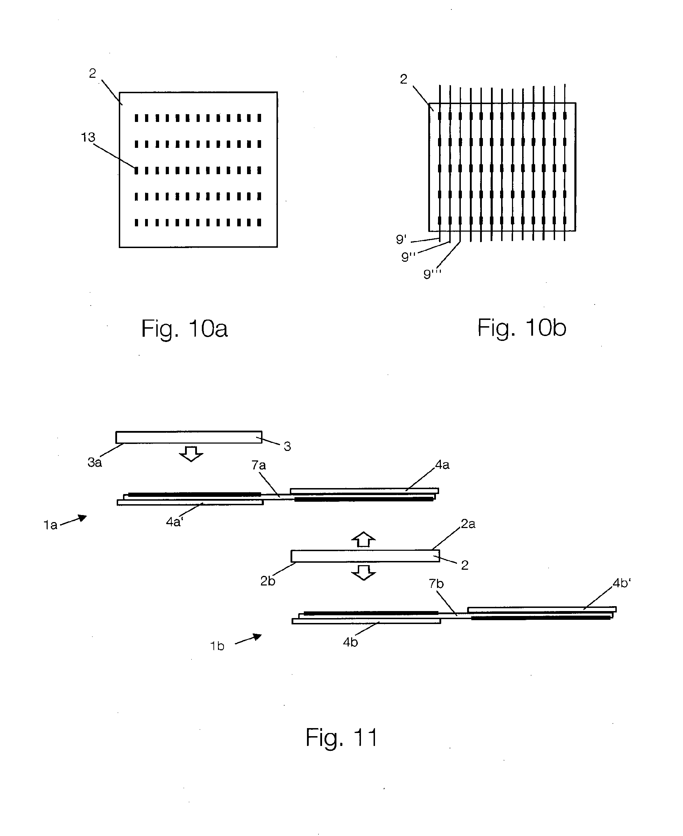

The coating and/or deformation of the wires does not have to be applied over the complete length of the wires and may be applied in structured manner both in the longitudinal direction of the wires as in the lateral direction of the wire, the latter e.g. being shown in figure 8. As shown in figures 10a and 10b a solar cell 2 with localized contact points 13 (e.g. metal-wrap-through solar cells or solar cells with partitioned fingers or a solar cell without metallization that has to be contacted in these regions) may be contacted with an interconnector with wires 9', 9", 9"' that are only coated in the regions corresponding to these contact points, thus structuring the coating in longitudinal direction.

Figure 11 shows the use of an interconnector 1 made according to the inventive method. First a first electrical conductor 7a of a first interconnector 1a is placed on a first face 2a of the first photovoltaic device 2, the first sheet 4a of the first interconnector 1 a and the first photovoltaic device 2 being on opposite sides of the electrical conductor 7a. Then the electrical conductor 7a of the first interconnector 1a is attached to the first photovoltaic device 2 heating and applying pressure to the first photovoltaic device 2, the electrical conductor 7a of the first interconnector 1 a and the first sheet 4a of the first interconnector 1 a.

Then the electrical conductor 7a is positioned on a first face 3a of a second photovoltaic device 3, the second sheet 4a' and the second photovoltaic device 3 being on opposite sides of the electrical conductor 7a and preferably the second sheet 4a' and the first sheet 4a being on opposite sides of the electrical conductor 7a. The electrical conductor 7a of the first interconnector 1 a is attached to the second photovoltaic device 3 by heating and applying pressure to the second photovoltaic device 3, the electrical conductor 7a of the first interconnector 1 a and the second sheet 4a' of the first interconnector.

To interconnect further solar cells, an electrical conductor 7b of a second interconnector 1 b is placed on a second face 2b of the first photovoltaic device 2, the first sheet 4b of the second interconnector 1 b and the first photovoltaic device 2 being on opposite sides of the electrical conductor 7b of the second interconnector 1 b, and the electrical conductor 7b of the second interconnector 1 b is attached to the first photovoltaic device 2 by heating and applying pressure to the first photovoltaic device 2, the electrical conductor 7b and the first sheet 4b of the second interconnector 1 b.

In this way strings and matrices of any desired number of solar cells can be formed.

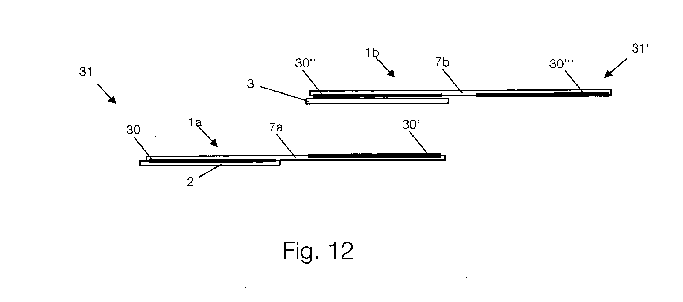

Figure 12 shows a first and a second electrical conductor 7a, 7b used to interconnect two solar cells 2,3, respectively forming a first and a second assembly of solar cells 31, 31'. The cross-sectional shape of the first and second interconnectors 7a, 7b are respectively changed forming coatings and/or defamations 30, 30' and 30", 30"' respectively. The electrical conductor 7a is attached to solar cell 2 with its coated/deformed portion 30. Its coated/deformed portion 30' is attached to a solar cell 3 that itself is attached to deformed portion 30" of electrical conductor 7b. In this way strings and even matrices of solar cells can be formed.

**List of reference marks**

| | | | |
|---|---|---|---|
| 1 | Interconnector | 14 | Coating |
| 1a, 1b | First and second interconnector | 15a-15b | Deformed wires |
| 2 | First photovoltaic device such as solar cell | 16', 16" | Cross-connector |
| 2a | First face of photovoltaic device | 17a-17b | Contours of non-deformed, circular |
| 2b | Second face of photovoltaic device | | wires |
| 3 | Second photovoltaic device | 18 | System for manufacturing an |
| 3a | First face of photovoltaic device | | interconnector |
| 4 | First sheet, sheet-like member or foil | 19', 19" | Wire coils |
| 4' | Second sheet, sheet-like member or foil | 20 | Heating drum |
| 5 | First surface of sheet | 21 a,b | First and second joining region |
| 5' | First surface of second sheet | 22-24 | Station for coating and/or deforming |
| 6 | First section of electrical conductor | | wires |
| 6a | First upstream portion of wire | 25a, b | Symmetrical portion of electrical |
| 6' | Second portion of electrical conductor | | conductor |
| 6" | Intermediate portion of wire altered | 26, 27 | First means for providing a first |
| 6a' | Second upstream portion of electrical conductor | 27 | member sheet-like Second means for providing a |
| 7 | Electrical conductor or wire | | second sheet-like member |
| 7a | First electrical conductor | 28 | Range outside portion 6, 6' |
| 7b | Second electrical conductor | 29 | First surface of first pv-device |
| 8 | First coating and/or deformation | 29' | First surface of second pv-device |
| 8' | Second coating and/or deformation | 30-30"' | Coating and/or deformation |
| 8a-8c | Coating | 31, 31' | Assembly of photovoltaic devices |
| 9'-9"' | Wires | | |
| 10, 10' | Mesh or grid | A | Longitudinal axis of wire |
| 11 | Second range of first/second portion | D | Distance between deforming/coating |
| 11' | Complete range of first/second portion | | and applying sheet |
| 12 | First range of first and/or second portion | E L | Length of edge of sheet Length of electrical conductor |
| 12' | Complete range of first and/or second portion | P | Plane parallel to the places the electrical conductors are located in |
| 13 | Contact point | v | Velocity of electrical conductor |

## Claims

1. A method for interconnecting photovoltaic devices such as solar cells (2,3), comprising the steps of:
i. providing at least one electrical wire (7) for electrically connecting at least two photovoltaic devices (2, 3),
ii. providing at least one first photovoltaic device (2) and/or at least one first sheet (4) respectively with at least one surface (5, 29) for receiving at least one first section (6) of the wire (7),
iii. changing the cross-sectional shape of the wire (7) in at least one first and/or one second section (6, 6'), preferably a section for contacting at least one of the surfaces (5, 29), to result in a new non-circular cross-sectional shape, the new cross-sectional shape having a defined spatial orientation to that surface (5, 29) after changing the cross-sectional shape,
iv. maintaining the defined spatial orientation of the section (6, 6') of the wire (7) or changing the spatial orientation of the section of wire (7) in a defined manner prior to and/or while combining and attaching wire (7) to the at least one surface (5, 29).

2. Method according to claim 1, **characterized in that** the first section (6) is allocated to the first photovoltaic device (2) and/or to the first sheet (4), preferably prior to changing its cross-sectional shape.

3. Method according to claim 1 or 2, **characterized in that** the cross-sectional shape of the wire (7) is changed by at least partially deforming and/or at least partially coating of that wire (7).

4. Method according to any of the preceding claims, **characterized in that** the spatial orientation of the electrical wire (7) prior to changing its cross-sectional shape is not defined.

5. Method according to any of the preceding claims, **characterized in that** the wire (7) prior to changing its cross-sectional shape has at least a 4-fold rotational symmetry around its longitudinal axis (A), preferably having an at least 5-fold rotational symmetry around its longitudinal axis (A), the wire preferably having a mainly circular cross-section (17a, 17b).

6. Method according to any of the preceding claims, **characterized in** the cross-sectional shape of the wire (7) being changed while combining and attaching wire (7) to surface (5) and/or after wire (7) has been combined and attached to surface (5).

7. Method according to any of the preceding claims, **characterized in** providing at least one second photovoltaic device (3) and/or at least one second sheet (4') with respectively at least one surface (5', 29') for receiving at least one second section (6') of wire (7).

8. Method according to any of the preceding claims, **characterized in that** the cross-sectional shape in a first range (12) of the first and/or second section (6, 6') of the wire (7) facing toward the surface (5, 29) it is received by is not changed, especially not coated,
preferably the cross-sectional shape of essentially the complete first range (12) of the first and/or second section (6, 6') in contact with the surface (5, 29) not being changed, especially not being coated.

9. Method according to any of the preceding claims, **characterized in that** the cross-sectional shape in a first range (12) of the first and/or second section (6, 6') of the wire (7) facing toward the surface (5, 29) it is received by is changed, especially deformed,
preferably the cross-sectional shape of essentially the complete first range (12) of the first and/or second section (6, 6') in contact with the surface (5, 29) being changed, especially being deformed.

10. Method according to any of the previous claims, **characterized in** at least two wires (7a, 7b) being provided, the wires preferably extending mainly parallel at least when attached to surface (5, 29) and/or the wires forming a mesh or grid (10, 10').

11. Interconnector (1) for interconnecting photovoltaic devices or an assembly (31) of interconnected photovoltaic devices comprising:
- at least a first sheet (4) and/or a first photovoltaic device (2) respectively with at least one surface (5, 29);
- at least one electrical wire (7) attached to that surface (5, 29);
- the wire having at least one first portion (6) with a non-circular cross-sectional shape and a second portion with a different, preferably circular cross-sectional shape.

12. Interconnector according to claim 11, **characterized in** the second portion(s) (6') having at least a 4-fold rotational symmetry around it longitudinal axis (A), preferably having an at least 5-fold rotational symmetry around it longitudinal axis (A), even more preferably that portion having a mainly circular cross-section.

13. Interconnector according to claims 11 or 12, comprising at least one second photovoltaic device (3) and/or at least one second sheet (4') that the at least one wire (7) is/are also attached to.

14. System (26) for manufacturing an interconnector (1) according to any of the claims 10 to 13 or for interconnecting photovoltaic devices such as solar cells (2,3) according to any of the methods of claims 1 to 10, **characterized in that** it comprises:
- means (19', 19", 20) for providing at least one electrical wire (7) to a joining region (21 a, 21b);
- means (26) for providing a first sheet (4) or a first photovoltaic device (2) to that joining region (21 a); and
- means (22, 23, 24) for changing the cross-sectional shape of wire (7), resulting in a new non-circular cross-sectional shape before it is provided to that joining region (21 a) or while it is **in that** joining region (21 a).

15. System (26) according to claim 14, **characterized in that** a means (20) is provided for attaching the first and/or second section (6,6') of the wire (7) to surface (5,5').
